# FASCICULE DE BREVET EUROPEEN

(11) **EP 3 573 241 B1**
(45) Date de publication et mention de la délivrance du brevet: **03.08.2022**
(21) Numéro de dépôt: 18174100.0
(22) Date de dépôt: 24.05.2018
(51) Int. Cl.: H03L 7/08, H03K 5/156, H03L 7/23

(54) **OSCILLATEUR DE RÉFÉRENCE À RAPPORT CYCLIQUE VARIABLE, SYNTHÉTISEUR DE FRÉQUENCE ET RÉCEPTEUR DE SIGNAUX AVEC L'OSCILLATEUR DE RÉFÉRENCE**
REFERENZOSZILLATOR MIT VARIABLEM ZYKLISCHEM TASTVERHÄLTNIS, FREQUENZGENERATOR UND SIGNALEMPFÄNGER MIT DIESEM REFERENZOSZILLATOR
REFERENCE OSCILLATOR WITH VARIABLE DUTY CYCLE, FREQUENCY SYNTHESISER AND SIGNAL RECEIVER WITH THE REFERENCE OSCILLATOR

(43) Date de publication de la demande: 27.11.2019
(73) Titulaire: The Swatch Group Research and Development Ltd, 2074 Marin (CH)
(72) Inventeur: Casagrande, Arnaud, 2014 Bôle (CH)
(74) Mandataire: ICB SA

(56) Documents cités:
- EP-A1- 0 358 518
- EP-A1- 2 869 483
- WO-A1-01/28100
- WO-A1-2008/067324
- US-A- 6 060 922
- US-A1- 2007 075 787
- US-A1- 2012 154 010

## Description

### DOMAINE TECHNIQUE DE L'INVENTION

L'invention concerne le domaine des oscillateurs de référence et, plus précisément dans ce domaine, les oscillateurs de référence comprenant un moyen de suppression ou de limitation d'au moins une harmonique haute. L'invention trouve des applications par exemple dans les domaines de la réception de signaux radiofréquences, de la conversion analogique-numérique, et de la synthèse de fréquence.

### ETAT DE LA TECHNIQUE

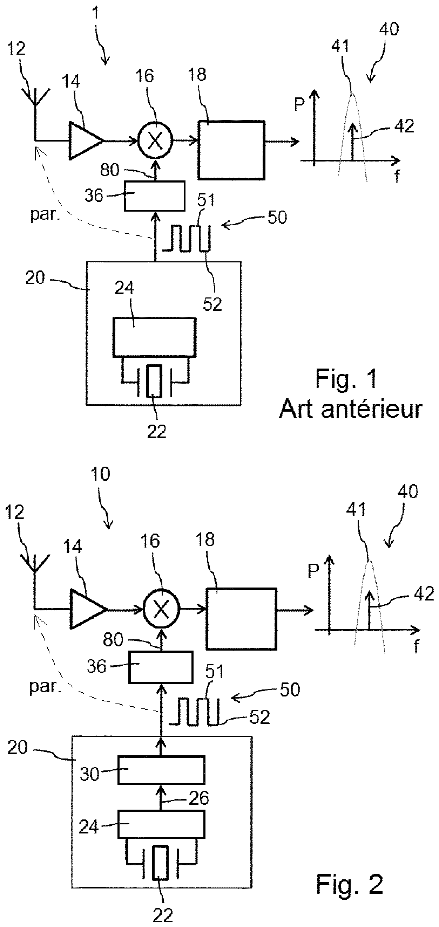

Pour la transmission de signaux électromagnétiques, en particulier de signaux radiofréquences, des récepteurs appropriés sont nécessaires. Un récepteur conventionnel est illustré à la figure 1. Le récepteur de signaux 1 comprend une antenne 12 pour la réception de signaux électromagnétiques. L'antenne 12 est reliée à un amplificateur à faible bruit 14 (LNA) adapté pour amplifier les signaux reçus par l'antenne 12. Le LNA est en outre relié à un mélangeur 16 pour mélanger les signaux amplifiés et reçus avec un signal oscillant 80 fourni par un circuit d'adaptation de fréquence 36, qui est généralement basé sur un oscillateur de référence 20. La sortie du mélangeur 16 est reliée à un filtre passe-bande (ou passe-bas) 18 pour filtrer les signaux intermédiaires 40 du mélangeur 16. Dans la figure 1, le spectre des signaux intermédiaires 40 est représenté par l'amplitude ou la puissance (p) sur la fréquence (f).

Typiquement, l'oscillateur de référence 20 utilise un générateur de signal 24 avec un résonateur de référence 22 tel qu'un résonateur à quartz, fournissant un signal de référence bien défini et stable. Par exemple, dans les applications typiques des résonateurs à quartz, le générateur de signal 24 avec le résonateur de référence 22 fonctionnent à une fréquence de référence de 26 MHz. Généralement, l'oscillateur de référence 20 fournit un signal de référence qui est utilisé comme base au circuit d'adaptation de fréquence 36.

Dans le cas d'une transmission par radiofréquence, le récepteur de signaux 1 peut par exemple fonctionner dans une plage Bluetooth, donc dans la bande des 2,4 GHz en utilisant un générateur de signal 24 avec un résonateur de référence à quartz 22 fonctionnant à 26 MHz. Par rayonnement et couplage parasite, les 93ème, 94ème et 95ème harmoniques hautes de la fréquence de l'oscillateur 20 basée sur le résonateur de référence 22 peuvent alors coïncider avec la fréquence des signaux RF utiles captés par l'antenne 12, et se retrouver convertis dans la bande 41 du filtre passe-bande (ou passe-bas) 18.

De manière générale, la forme d'onde particulière du signal de référence introduit par couplage parasite des harmoniques élevées du signal 50 sur l'entrée 12 (flèche en pointillés sur la figure 1) dans les signaux intermédiaires des repliements du signal de référence non désirés et polluants (présents dans la bande de fréquence 41 du filtre 18). Ces harmoniques ont pour conséquence, localement sur leur fréquence spécifique, une réduction de la sensibilité du récepteur. La fréquence exacte de ces harmoniques, ainsi que leur amplitude, dépend directement du rapport cyclique du signal oscillant qui, s'il n'est pas contrôlé, dépend de manière statistique des conditions de réalisation (procédé de fabrication) et d'utilisation (température, tension) du circuit intégré comprenant l'oscillateur, ainsi que des variations typiques du résonateur de référence et de ses connexions (PCB ou carte sur lequel est réalisé le circuit intégré comprenant le résonateur, boîtage, ...).

Les signaux intermédiaires reçus par le filtre peuvent donc être sévèrement perturbés par les composantes harmoniques à haute fréquence du signal issu du résonateur de référence (injecté de manière parasite par couplage sur le signal RF désiré). Ce problème devient encore plus important lorsque le récepteur de signaux est implémenté dans un seul circuit intégré. Ce problème est encore plus important dans les circuits numériques, du fait des transitions très raides du signal de référence (ou d'horloge) et des pics de consommation synchrones des circuits logiques.

La demande de brevet EP 2 869 483 A1 décrit en détail ce problème, et propose de supprimer au moins une de ces harmoniques par un ajustement du rapport cyclique du signal de l'oscillateur. L'ajustement est effectué pas à pas, par des variations incrémentales du rapport cyclique ajustées en fonction d'une mesure de l'effet d'une variation précédente, jusqu'à l'obtention d'une perturbation minimale.

Cette solution est intéressante dans la mesure où elle permet de minimiser très fortement et même de supprimer les harmoniques polluant le signal de sortie 40 du récepteur. Cependant, cette solution nécessite un temps d'établissement à chaque activation. Ce temps d'activation peut être important, voire trop important pour certaines applications.

Le document US 6,060,922 A décrit un circuit de contrôle tampon d'un rapport cyclique en liaison avec un oscillateur adapté pour un émetteur ou récepteur de signaux électromagnétiques. Un circuit diviseur de fréquence sélectif (f/N) est placé avant le circuit de contrôle d'un rapport cyclique pour diviser un signal d'horloge en entrée. Le circuit de contrôle ajuste automatiquement le rapport cyclique d'un signal d'horloge d'entrée via une fonction en boucle fermée. Le circuit n'est pas prévu pour minimiser ou supprimer une composante harmonique du signal de référence modifié.

### RESUMÉ DE L'INVENTION

L'invention a pour objet de fournir une solution alternative à la solution proposée dans la demande de brevet EP 2 869 483 A1, qui ne nécessite pas de temps d'établissement au démarrage.

A cet effet, l'invention définie par la revendication 1, propose un nouvel oscillateur de référence pour un émetteur et/ou un récepteur de signaux radiofréquences. L'oscillateur de référence est adapté pour générer un signal de référence modifié alternant des temps ON et des temps OFF avec un rapport cyclique prédéfini à partir d'un signal fourni par un résonateur de référence. L'oscillateur de référence comprend un circuit d'ajustement adapté pour ajuster le rapport cyclique du signal de référence modifié en fonction d'au moins un paramètre d'ajustement prédéfini de sorte à minimiser au moins une composante harmonique du signal de référence modifié.

Ainsi, en ajustant de manière appropriée et déterministe le rapport cyclique du signal de référence modifié produit par l'oscillateur de référence selon l'invention, il est possible de minimiser les pollutions générées par certaines harmoniques du signal de référence modifié, par exemple autour d'une fréquence particulière. De plus, comme le rapport cyclique est ajusté par des paramètres prédéterminés, en fonction notamment du rang de la ou des harmoniques à minimiser, et non pas par ajustements successifs, le rapport cyclique est ajusté dès l'activation de l'oscillateur.

L'oscillateur comprend également un générateur de référence couplé au résonateur pour produire un signal initial de référence, le circuit d'ajustement étant couplé au générateur de référence pour générer le signal de référence modifié de rapport cyclique prédéfini à partir du signal initial de référence.

Le circuit d'ajustement de l'oscillateur comprend un circuit pour synchroniser le signal de référence modifié sur un flanc du signal initial de référence. Ceci permet de pallier une éventuelle dérive de phase qui pourrait apparaître dans le circuit d'ajustement.

Selon un mode de mise en œuvre, le récepteur comprend une interface Homme/Machine pour permettre à un utilisateur de fournir au circuit d'ajustement au moins un paramètre d'ajustement du rapport cyclique. L'ajustement du rapport cyclique est ainsi immédiat, dès l'activation de l'oscillateur de référence, et le rapport cyclique peut être ajusté en temps réel en cas de changement de la fréquence autour de laquelle les harmoniques doivent être minimisées.

L'invention propose également un synthétiseur de fréquence comprenant un oscillateur de référence, tel que défini par l'une des revendications 1 et 2 et un circuit adaptateur de fréquence pour produire un signal oscillant haute fréquence à partir du signal de référence modifié. En ajustant le rapport cyclique du circuit d'ajustement de l'oscillateur de référence, le signal oscillant haute fréquence présente l'avantage d'être dépollué de ses harmoniques autour d'une fréquence particulière, et ce dès l'activation de l'oscillateur de référence.

Selon un mode de réalisation, le circuit d'adaptation de fréquence comprend une boucle PLL agencée pour recevoir le signal de référence modifié de fréquence f_{ref} et produire un signal oscillant de plus haute fréquence x·f_{ref}.

L'invention propose encore un récepteur de signaux, comprenant :
- une antenne pour la réception de signaux électromagnétiques,
- au moins un amplificateur à faible bruit pour amplifier les signaux reçus par l'antenne,
- au moins un oscillateur de référence, tel que décrit ci-dessus ou au moins un synthétiseur de fréquence également décrit ci-dessus, agencé pour produire un signal de référence modifié ou un signal oscillant haute fréquence de rapport cyclique prédéfini,
- un mélangeur pour mélanger les signaux amplifiés et reçus avec le signal de référence modifié ou avec le signal oscillant haute fréquence pour générer des signaux intermédiaires,
- un filtre pour filtrer les signaux intermédiaires,
l'oscillateur de référence comprenant un circuit d'ajustement adapté pour ajuster le rapport cyclique en fonction d'une fréquence des signaux électromagnétiques reçus pour minimiser une amplitude d'au moins une composante harmonique haute du signal de référence modifié et présente dans les signaux intermédiaires filtrés.

Ainsi, dans le récepteur selon l'invention, le rapport cyclique du signal de référence modifié est prédéfini en fonction d'une fréquence des signaux reçus sur l'antenne, pour minimiser l"influence des éventuelles harmoniques présentes autour de la fréquence des signaux reçus sur l'antenne. Et le rapport cyclique optimal est fixé dès l'activation du récepteur, et aucun temps d'établissement n'est plus nécessaire à chaque activation du récepteur pour avoir une réception optimisée.

### BRÈVE DESCRIPTION DES FIGURES

L'invention sera décrite ci-après de manière plus détaillée à l'aide des dessins annexés, donnés à titre d'exemples nullement limitatifs, dans lesquels :
- la figure 1 montre un schéma d'un récepteur de signaux selon l'art antérieur,
- la figure 2 montre un schéma d'un récepteur selon l'invention,
- la figure 3 montre un schéma d'un oscillateur de référence selon l'invention produisant un signal de référence modifié à rapport cyclique contrôlé, et
- la figure 4 montre un schéma d'un synthétiseur de fréquence selon l'invention produisant un signal haute fréquence à rapport cyclique contrôlé.

### DESCRIPTION DETAILLEE DE L'INVENTION

Comme dit précédemment, l'invention propose un nouvel oscillateur de référence 20. L'invention propose également un synthétiseur de fréquence 70 et un récepteur de signaux comprenant un oscillateur de référence 20.

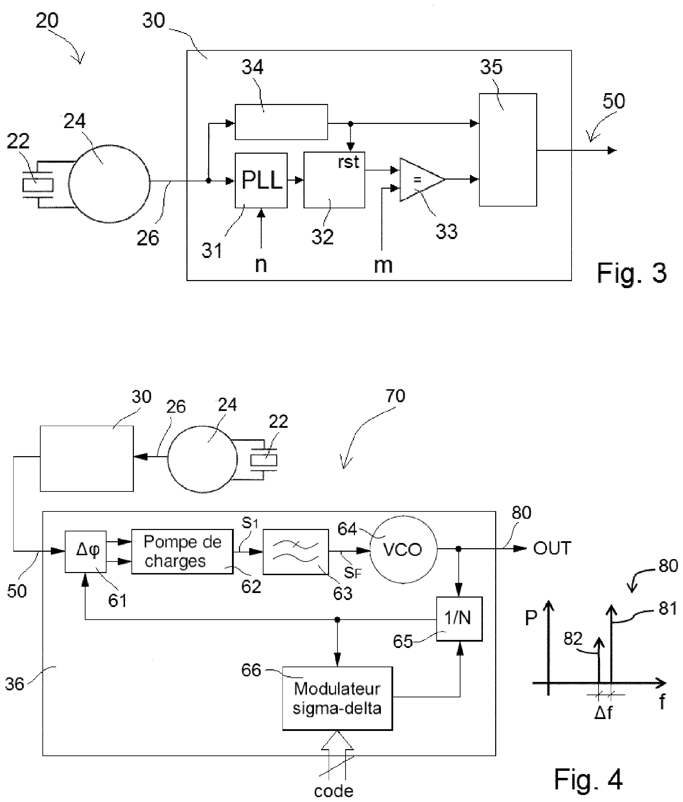

La figure 3 détaille un oscillateur de référence 20 selon l'invention, par exemple un oscillateur MEMS ou à cristal de quartz. Il comprend un générateur de référence 24 verrouillé sur un résonateur de référence 22. Le résonateur 22 peut être un résonateur MEMS, un résonateur à cristal de quartz, ou un résonateur similaire. Des exemples de mise en œuvre du résonateur 22 et du générateur de référence 24 sont également décrits dans la demande de brevet EP 2 869 483 A1. Le générateur de signal 24 fournit un signal initial de référence 26 de fréquence de référence f_{ref} constante et stable, typiquement dans la gamme de plusieurs MHz, par exemple 26 MHz.

Dans un oscillateur de référence 20 selon l'invention, comme représenté en figure 3, le générateur 24 est connecté à un circuit d'ajustement 30 du rapport cyclique. Le circuit 30 génère, sur la base du signal initial de référence 26 provenant du générateur de signal 24, un signal de référence modifié 50 ayant par exemple une forme d'onde rectangulaire présentant une séquence alternée de temps ON 51 et OFF 52. Le rapport cyclique r définit la relation entre la durée des temps ON 51 et la durée des temps OFF 52 du signal de référence modifié 50.

Dans l'oscillateur 20 selon l'invention, le circuit d'ajustement 30 du rapport cyclique est agencé pour fournir un signal de référence modifié ayant un rapport cyclique r prédéfini en fonction d'au moins un paramètre d'ajustement de sorte à minimiser au moins une composante harmonique du signal de référence modifié 50. Dans l'exemple de la figure 2, l'oscillateur de référence 20 est utilisé pour réaliser un récepteur de signaux et au moins un paramètre d'ajustement est choisi en fonction d'une fréquence des signaux électromagnétiques reçus sur l'antenne ou amplifiés, comme on le verra mieux plus loin.

Pour un signal rectangulaire, l'amplitude d'une harmonique de rang h est proportionnelle à [sin(pi·h·r)]/(pi·h·r), où pi est la constante d'Archimède, r est le rapport cyclique du signal rectangulaire, et h est le rang de l'harmonique considérée. Fixer le rapport cyclique r permet ainsi de minimiser l'amplitude d'au moins une composante harmonique haute du signal de référence modifié 50 injectée de manière parasite dans le spectre du signal RF désiré et donc de minimiser la pollution harmonique au voisinage de la fréquence reçue. Comme montré par la flèche en pointillés sur la figure 2, le signal de référence modifié 50 introduit par couplage parasite des harmoniques élevées du signal 50 sur l'entrée 12.

Selon un mode de réalisation, l'oscillateur de référence 20 comprend une interface Homme / Machine IHM (non représentée) pour permettre à un utilisateur de fournir au circuit d'ajustement au moins un paramètre d'ajustement du rapport cyclique. Selon un mode de mise en œuvre concrète, l'IHM peut comprendre un bouton de sélection permettant à l'utilisateur de sélectionner une fréquence des signaux à recevoir, et une mémoire, mémorisant une table comprenant, pour chaque fréquence de signaux susceptibles d'être reçus, le ou les paramètres nécessaires à l'ajustement du rapport cyclique.

Selon le mode de réalisation de la figure 3, le circuit d'ajustement 30 comprend un circuit pour générer le signal de référence modifié, circuit comprenant une boucle à verrouillage de phase ou PLL 31, un compteur 32, un comparateur 33 et un générateur d'impulsions 34. La PLL 31 est connectée au générateur de référence 24, et produit un signal de fréquence n fois supérieure à la fréquence f_{ref} du signal de référence (f = n·f_{ref}). Le compteur 32 est connecté à la PLL et compte des impulsions du signal produit par la PLL. Le compteur est choisi pour être en capacité de compter au-delà du nombre n. Le comparateur 33 est connecté à une sortie du compteur 32 et compare un nombre d'impulsions comptées à une valeur prédéfinie m. Le comparateur 33 produit un signal ON si le nombre d'impulsions comptées est inférieur à la valeur prédéfinie m ou un signal OFF sinon. Enfin, le générateur d'impulsions 34 est connecté au générateur de référence 24. Il produit un signal d'initialisation de même fréquence f_{ref} que le signal initial de référence, le signal d'initialisation est ici un signal impulsionnel, comprenant une suite d'impulsions, une impulsion étant produite par exemple à chaque front montant du signal de référence 26. Le signal d'initialisation est appliqué sur une entrée d'initialisation du compteur pour mettre à zéro le compteur. Les paramètres d'ajustement m, n ou m/n sont fournis en fonction de l'application envisagée, par exemple par l'intermédiaire de l'interface IHM.

Le signal de référence modifié obtenu en sortie du comparateur est un signal rectangulaire, de fréquence f_{ref} et qui, sur une période T, est égal à ON pendant un premier temps T1 = m/f_{ref} et égal à OFF sinon. Le rapport cyclique du signal de référence modifié obtenu dans cet exemple de réalisation est ainsi égal à r = m/n = T1/T et est imposé par les paramètres m et n. Selon l'invention, les paramètres m et n sont prédéfinis comme expliqué ci-dessus.

Selon le mode de réalisation de la figure 3, le circuit d'ajustement comprend également un circuit 35 pour synchroniser le signal de référence modifié sur un flanc du signal initial de référence 26. Le circuit de synchronisation permet de pallier une éventuelle dérive en phase du circuit d'ajustement 30. Il permet ainsi par exemple d'utiliser une PLL 31 ayant des caractéristiques de bruit assez médiocres, mais ayant l'avantage d'être de puissance et taille réduites.

Le circuit de synchronisation 35 est dans l'exemple de la figure 3 une bascule RS dont une entrée SET est connectée au générateur d'impulsions 34 et dont une entrée RESET est connectée en sortie du comparateur 33, le signal de référence modifié synchronisé 50 étant disponible sur une sortie de la bascule 35 qui peut être reliée à un circuit d'adaptation de fréquence 36 d'un récepteur RF. Chaque fois qu'elle reçoit le signal d'initialisation sur son entrée SET, la sortie de la bascule RS passe de OFF à ON. Le signal en sortie de la bascule est ainsi synchronisé sur un flanc du signal initial de référence 26.

La figure 4 détaille un mode de réalisation d'un synthétiseur de fréquence selon l'invention comprenant un oscillateur de référence 20 et un circuit d'adaptation de fréquence 36 pour produire un signal oscillant haute fréquence OUT 80. L'oscillateur de référence 20 est par exemple identique à celui de la figure 3. Le circuit adaptateur de fréquence est ici une boucle PLL 36 comprenant un oscillateur commandé en tension VCO 64, un circuit diviseur 65, un détecteur de phase 61, une pompe de charges différentielle 62, un filtre passe-bas 63, et un circuit de paramétrage 66.

Il est à noter également que le signal de référence modifié 50 peut introduire aussi par couplage parasite des harmoniques élevées du signal 50 à l'entrée du VCO 64.

L'oscillateur 64 fournit le signal oscillant haute fréquence OUT dans une bande de fréquence déterminée. Le circuit diviseur 65 divise la fréquence du signal OUT par un facteur N afin de fournir un signal à fréquence divisée f_{div}. Le circuit 66 permet d'ajuster le facteur N en fonction d'une fréquence souhaitée et de la fréquence divisée f_{div}. Le détecteur de phase 61 compare le signal de référence modifié 50 à fréquence de référence f_{ref} avec le signal à fréquence divisée fourni par le circuit diviseur. Le détecteur de phase 61 fournit deux signaux de commande HAUT, BAS (UP, DOWN en terminologie anglaise) fonction du résultat de la comparaison à la pompe de charges différentielle 62. La pompe de charges 62 injecte ou retire des charges dans le filtre 63 en fonction des signaux HAUT ou BAS. Le filtre passe-bas 63 filtre le signal de sortie S₁ de la pompe de charges pour fournir un signal filtré S_{F} de commande à l'oscillateur commandé en tension 64.

Le spectre du signal oscillant haute fréquence 80 montre le signal fréquentiel fourni par l'oscillateur 64, signal comprenant une composante principale fout 81 et une pollution harmonique fₚ 82 générée par une harmonique du signal initial de référence 26. Lorsque la composante principale 81 et la pollution harmonique 82 sont trop proches l'une de l'autre, l'oscillateur 64 produit une série d'harmoniques additionnelles de fréquence fout ± k·(fₒᵤₜ - fₚ), phénomène connu sous le nom de « VCO pulling ». Le circuit d'ajustement 30 permet ici avantageusement de limiter l'harmonique 82 du signal initial de référence 26, et ainsi de limiter le phénomène de « VCO pulling ».

Enfin, la figure 2 détaille un récepteur 10 de signal selon l'invention. Le récepteur comprend une antenne 12, un amplificateur à faible bruit LNA 14, un mélangeur 16 et un filtre 18 passe-bande ou passe-bas. L'antenne 12 est adaptée pour recevoir des signaux électromagnétiques. Selon l'invention, le récepteur comprend également un synthétiseur de fréquence de référence comprenant un oscillateur de référence 20 selon l'invention et un circuit d'adaptation de fréquence 36. L'amplificateur 14 est connecté à l'antenne 12 pour amplifier les signaux reçus par l'antenne 12. L'oscillateur de référence 20 comprend un résonateur de référence 22 pour générer un signal de référence modifié 50 alternant des temps ON et des temps OFF avec un rapport cyclique prédéfini. Le mélangeur 16 est connecté à l'amplificateur 14 et au circuit d'adaptation de fréquence 36 pour mélanger les signaux amplifiés et reçus avec le signal haute fréquence OUT 80 et pour générer des signaux intermédiaires 40. Enfin, le filtre passe-bande (ou passe-bas) 18 est connecté en sortie du mélangeur pour filtrer les signaux intermédiaires 40. Des exemples de mise en œuvre de l'antenne 12, l'amplificateur 14, le mélangeur 16 et le filtre 18 sont décrits en détails dans la demande de brevet EP 2 869 483 A1, incorporée ici par référence. L'oscillateur de référence 20 et le circuit d'adaptation de fréquence 36 peuvent être réalisés conformément aux figures 3 et 4. A noter que le circuit d'adaptation de fréquence 36 est utile ici uniquement si les signaux reçus sur l'antenne ont une fréquence éloignée de la fréquence du signal de référence. Dans le cas contraire, le récepteur peut être réalisé sans circuit d'adaptation de fréquence 36.

A partir de la description qui vient d'être faite, plusieurs variantes de l'oscillateur de référence, du synthétiseur de fréquence et du récepteur de signaux peuvent être conçues par l'homme du métier sans sortir du cadre de l'invention définie par les revendications.

## Revendications

1. Oscillateur de référence (20) pour un émetteur et/ou un récepteur de signaux électromagnétiques, l'oscillateur de référence (20) étant adapté pour générer un signal de référence modifié (50) alternant des temps ON et des temps OFF avec un rapport cyclique prédéfini à partir d'un signal fourni par un résonateur de référence (22), l'oscillateur de référence (20) comprenant également un circuit d'ajustement (30) adapté pour ajuster le rapport cyclique du signal de référence modifié (50) en fonction d'au moins un paramètre d'ajustement de sorte à minimiser au moins une composante harmonique haute du signal de référence modifié (50), injectée de manière parasite dans un spectre de signaux électromagnétiques, et un générateur de référence (24) couplé au résonateur (22) pour produire un signal initial de référence (26), le circuit d'ajustement étant couplé au générateur de référence (24) pour générer le signal de référence modifié (50) de rapport cyclique prédéfini à partir du signal initial de référence (26),
caracrérisé en ce que le circuit d'ajustement générant le signal de référence modifié (50) comprend :
- une boucle à verrouillage de phase ou PLL (31), connectée au générateur de référence (24) et adaptée pour produire un signal de fréquence n fois supérieure à la fréquence f_{ref} du signal initial de référence (26),
- un compteur (32) connecté à la boucle PLL pour compter des impulsions du signal produit par la boucle PLL,
- un comparateur (33) pour comparer un nombre d'impulsions comptées à une valeur prédéfinie m, et produire un signal ON si le nombre d'impulsions comptées est inférieur à la valeur prédéfinie m ou un signal OFF sinon,
- un générateur d'impulsions (34) connecté au générateur de référence et agencé pour produire un signal impulsionnel d'initialisation à partir du signal initial de référence (26) et étant de même fréquence que le signal initial de référence, ledit signal impulsionnel d'initialisation étant appliqué sur une entrée d'initialisation du compteur, et
- un circuit de synchronisation (35) pour synchroniser le signal de référence modifié (50) sur un flanc du signal initial de référence (26), et
en ce que le circuit de synchronisation comprend une bascule RS dont une entrée SET est connectée en sortie du générateur d'impulsions et dont une entrée RESET est connectée en sortie du comparateur, le signal oscillant modifié synchronisé (50) étant disponible sur une sortie de la bascule

2. Oscillateur de référence (20) selon la revendication 1, comprenant également une interface Homme/Machine (IHM) pour permettre à un utilisateur de fournir au circuit d'ajustement au moins un paramètre d'ajustement du rapport cyclique.

3. Synthétiseur de fréquence (70) comprenant un oscillateur de référence (20) selon l'une des revendications 1 et 2 et un circuit d'adaptation de fréquence (36) pour produire un signal oscillant haute fréquence (80).

4. Synthétiseur de fréquence (70) selon la revendication 3 dans lequel le circuit d'adaptation de fréquence comprend une boucle PLL (36) agencée pour recevoir le signal de référence modifié (50) de fréquence f_{ref} et produire un signal oscillant de plus haute fréquence x·f_{ref}.

5. Synthétiseur de fréquence (70) selon la revendication 4 dans lequel circuit d'adaptation de fréquence (36) comprend :
- un oscillateur commandé en tension VCO (64) pour fournir le signal oscillant haute fréquence OUT (80),
- un circuit diviseur (65) pour diviser la fréquence du signal OUT par un facteur N afin de fournir un signal à fréquence divisée f_{div},
- un détecteur de phase (61) pour comparer le signal de référence modifié (50) à fréquence de référence f_{ref} avec le signal à fréquence divisée f_{div} fourni par le circuit diviseur et fournir deux signaux de commande HAUT, BAS fonction du résultat de la comparaison,
- une pompe de charges (62) pour recevoir les deux signaux de commande HAUT, BAS du détecteur de phase (61), et
- un filtre passe-bas (63) pour filtrer un signal de sortie (S₁) de la pompe de charges (62) pour fournir un signal filtré (S_{F}) de commande à l'oscillateur commandé en tension (64).

6. Récepteur de signaux (10), comprenant :
- une antenne (12) pour la réception de signaux électromagnétiques,
- au moins un amplificateur à faible bruit (14) pour amplifier les signaux reçus par l'antenne (12),
- au moins un oscillateur de référence (20) selon la revendication 1 ou au moins un synthétiseur de fréquence (70) selon la revendication 3 pour produire un signal de référence modifié (50) ou un signal oscillant haute fréquence (80) de rapport cyclique prédéfini,
- un mélangeur (16) pour mélanger les signaux amplifiés et reçus avec le signal de référence modifié (50) ou avec le signal oscillant haute fréquence (80) pour générer des signaux intermédiaires (40), et
- un filtre (18) pour filtrer les signaux intermédiaires (40), un circuit d'ajustement (30) de l'oscillateur de référence (20) étant adapté pour ajuster le rapport cyclique en fonction d'une fréquence des signaux électromagnétiques reçus pour minimiser l'amplitude d'au moins une composante harmonique haute du signal de référence modifié (50), injectée de manière parasite dans un spectre de signaux électromagnétiques, et présente (42) dans les signaux intermédiaires filtrés (40).

## Patentansprüche

1. Referenzoszillator (20) für einen Sender und/oder einen Empfänger von elektromagnetischen Signalen, wobei der Referenzoszillator (20) dafür ausgelegt ist, ein modifiziertes Referenzsignal (50) zu erzeugen, das abwechselnd EIN- und AUS-Zeiten aufweist mit einem Tastverhältnis, das aus einem von einem Referenzresonator (22) gelieferten Signal vordefiniert ist, wobei der Referenzoszillator (20) auch eine Einstellschaltung (30) umfasst, die zum Einstellen das Tastverhältnisses des modifizierten Referenzsignals (50) in Abhängigkeit von mindestens einem Anpassungsparameter geeignet ist, so dass mindestens eine hochharmonische Komponente des modifizierten Referenzsignals (50) minimiert wird, die parasitär in ein Spektrum elektromagnetischer Signale eingespeist wird, und einen Referenzgenerator (24) umfasst, der mit dem Resonator (22) gekoppelt ist, um ein anfängliches Referenzsignal (26) zu erzeugen, wobei die Einstellschaltung mit dem Referenzgenerator (24) gekoppelt ist, um das modifizierte Referenzsignal (50) zu erzeugen mit einem Tastverhältnis, das aus dem anfänglichen Referenzsignal (26) vordefiniert wurde,
**dadurch gekennzeichnet, dass** die Einstellschaltung, die das modifizierte Referenzsignal (50) erzeugt, umfasst:
- eine Phasenregelschleife oder PLL (31), die mit dem Referenzgenerator (24) verbunden ist und dafür ausgelegt ist, ein Frequenzsignal zu erzeugen, das n-mal größer ist als die Frequenz f_{ref} des anfänglichen Referenzsignals (26),
- einen Zähler (32), der mit der PLL-Schleife verbunden ist, um die Anzahl von Impulsen des von der PLL-Schleife erzeugten Signals zu zählen,
- einen Komparator (33) zum Vergleichen einer Anzahl gezählter Impulse mit einem vorgegebenen Wert m und zum Erzeugen eines EIN-Signals, wenn die Anzahl gezählter Impulse kleiner als der vorgegebene Wert m ist, oder sonst eines AUS-Signals,
- einen Impulsgenerator (34), der mit dem Referenzgenerator verbunden ist und dafür ausgelegt ist, ausgehend von dem des anfänglichen Referenzsignal (26) ein Anfangs-Impulssignal zu erzeugen, das die gleiche Frequenz wie das anfängliche Referenzsignal besitzt, wobei das Anfangs-Impulssignal in einen Initialisierungseingang des Zählers angewendet wird, und
- eine Synchronisationsschaltung (35) zum Synchronisieren des modifizierten Referenzsignals (50) mit einer Flanke des anfänglichen Referenzsignals (26), und
dass die Synchronisationsschaltung ein RS-Flip-Flop umfasst, dessen einer SET-Eingang mit dem Ausgang des Impulsgenerators verbunden ist und dessen einer RESET-Eingang mit dem Ausgang des Komparators verbunden ist, wobei das modifizierte synchronisierte Oszillationssignal an einem Ausgang des Flip-Flops zur Verfügung steht.

2. Referenzoszillator (20) nach Anspruch 1, der ferner eine Mensch-Maschine-Schnittstelle (HMI) umfasst, um einem Benutzer zu ermöglichen, der Einstellschaltung mindestens einen Einstellparameter des Tastverhältnisses anzugeben.

3. Frequenzsynthesizer (70), der einen Referenzoszillator (20) nach einem der Ansprüche 1 und 2 und eine Frequenzanpassungsschaltung (36) zum Erzeugen eines hochfrequenten oszillierenden Signals (80) umfasst.

4. Frequenzsynthesizer (70) nach Anspruch 3, wobei die Frequenzanpassungsschaltung eine PLL-Schleife (36) umfasst, die dafür ausgelegt ist, das modifizierte Referenzsignal (50) mit der Frequenz f_{ref} zu empfangen und ein oszillierendes Signal mit einer höheren Frequenz x · f_{ref} zu erzeugen.

5. Frequenzsynthesizer (70) nach Anspruch 4, wobei die Frequenzanpassungsschaltung (36) umfasst:
- einen spannungsgesteuerten Oszillator VCO (64) zum Bereitstellen des hochfrequenten oszillierenden Signals OUT (80),
- eine Teilerschaltung (65) zum Teilen der Frequenz des Out-Signals durch einen Faktor N, um ein frequenzgeteiltes Signal fdiv zu liefern,
- einen Phasendetektor (61) zum Vergleichen des modifizierten Referenzsignals (50) mit der Referenzspannung f_{ref} mit dem Signal mit geteilter Frequenz f_{div}, das von der Teilerschaltung geliefert wird, und zum Liefern zweier Steuersignale HOCH, NIEDRIG in Abhängigkeit des Ergebnisses des Vergleichs,
- eine Ladungspumpe (62) zum Empfangen der beiden Steuersignale HOCH, NIEDRIG vom Phasendetektor (61), und
- ein Tiefpassfilter (63) zum Filtern eines Ausgangssignals (S₁) der Ladungspumpe (62), um ein gefiltertes Steuersignal (S_{F}) an den spannungsgesteuerten Oszillator (64) zu liefern.

6. Signalempfänger (10), umfassend:
- eine Antenne (12) für den Empfang elektromagnetischer Signale,
- mindestens einen rauscharmen Verstärker (14) zum Verstärken der von der Antenne (12) empfangenen Signale,
- mindestens einen Referenzoszillator (20) nach Anspruch 1 oder mindestens einen Frequenzsynthesizer (70) nach Anspruch 3 zum Erzeugen eines modifizierten Referenzsignals (50) oder eines hochfrequenten oszillierenden Signals (80) mit einem vordefinierten Tastverhältnis,
- einen Mischer (16) zum Mischen der verstärkten und wiedergegebenen Signale mit dem modifizierten Referenzsignal (50) oder mit dem hochfrequenten oszillierenden Signal (80) zur Erzeugung von Zwischensignalen (40), und
- ein Filter (18) zum Filtern der Zwischensignale (40), wobei eine Einstellschaltung (30) des Referenzoszillators (20) dafür ausgelegt ist, das Tastverhältnis in Abhängigkeit von einer Frequenz der empfangenen elektromagnetischen Signale einzustellen, um die Amplitude von mindestens einer hohen harmonischen Komponente des modifizierten Referenzsignals (50), die auf parasitäre Weise in ein Spektrum elektromagnetischer Signale eingegeben wird und in den gefilterten Zwischensignalen (40) vorhanden ist, zu minimieren.

## Claims

1. Reference oscillator (20) for a transmitter and/or a receiver of electromagnetic signals, the reference oscillator (20) being suitable for generating a modified reference signal (50) alternating ON times and OFF times with a predefined duty cycle from a signal supplied by a reference resonator (22), the reference oscillator (20) also comprising an adjustment circuit (30) suitable for adjusting the duty cycle of the modified reference signal (50) according to at least one adjustment parameter so as to minimise at least one higher harmonic component of the modified reference signal (50), injected parasitically into a spectrum of electromagnetic signals, and a reference generator (24) coupled to the resonator (22) for producing an initial reference signal (26), the adjustment circuit being coupled to the reference generator (24) for generating the modified reference signal (50) with a predefined duty cycle from the initial reference signal (26), **characterised in that** the adjustment circuit generating the modified reference signal (50) comprises:
- a phase-locked loop or PLL (31), connected to the reference generator (24) and suitable for producing a signal of frequency n times greater than the frequency f_{ref} of the initial reference signal (26),
- a counter (32) connected to the PLL loop for counting the pulses of the signal produced by the PLL loop,
- a comparator (33) for comparing a number of pulses counted to a predefined value m, and producing an ON signal if the number of pulses counted is less than the predefined value m or an OFF signal otherwise,
- a pulse generator (34) connected to the reference generator and arranged for producing an initialising pulse signal from the initial reference signal (26) and being of the same frequency as the initial reference signal, said initialising pulse signal being applied to an initialising input of the counter, and
- a circuit (35) for synchronising the modified reference signal (50) on one flank of the initial reference signal (26), and
**in that** the synchronisation circuit comprises an RS flip-flop, a SET input of which is connected to the output of the pulse generator and a RESET input of which is connected to the output of the comparator, the synchronised modified oscillating signal (50) being available at an output of the flip-flop.

2. Reference oscillator (20) according to claim 1, also comprising a Man/Machine interface (MMI) for enabling a user to supply the adjustment circuit with at least one adjustment parameter of the duty cycle.

3. Frequency synthesiser (70) comprising a reference oscillator (20) according to one of claims 1 and 2 and a frequency matching circuit (36) for producing a high frequency oscillating signal (80).

4. Frequency synthesiser (70) according to claim 3, wherein the frequency matching circuit comprises a PLL loop (36) arranged for receiving the modified reference signal (50) of frequency f_{ref} and producing an oscillating signal of higher frequency x·f_{ref}.

5. Frequency synthesiser (70) according to claim 4, wherein the frequency matching circuit (36) comprises:
- a voltage controlled oscillator VCO (64) for supplying the high frequency oscillating signal OUT (80),
- a divider circuit (65) for dividing the frequency of the signal OUT by a factor N in order to supply a divided frequency signal f_{div},
- a phase detector (61) for comparing the modified reference signal (50) at a reference frequency f_{ref} with the divided frequency signal f_{div} supplied by the divider circuit and supplying two control signals UP, DOWN according to the result of the comparison,
- a charge pump (62) for receiving the two control signals UP, DOWN of the phase detector (61), and
- a low-pass filter (63) for filtering an output signal (S₁) of the charge pump (62) for supplying a filtered control signal (S_{F}) to the voltage-controlled oscillator (64).

6. Signal receiver (10), comprising:
- an antenna (12) for receiving electromagnetic signals,
- at least one low noise amplifier (14) for amplifying the signals received by the antenna (12),
- at least one reference oscillator (20), according to claim 1 or at least one frequency synthesiser (70) according to claim 3 for producing a modified reference signal (50) or a high frequency oscillating signal with a predefined duty cycle (80),
- a mixer (16) for mixing the amplified and received signals with the modified reference signal (50) or with the high frequency oscillating signal (80) for generating intermediate signals (40), and
- a filter (18) for filtering the intermediate signals (40), an adjustment circuit (30) of the reference oscillator (20) being suitable for adjusting the duty cycle according to a frequency of the electromagnetic signals received for minimising the amplitude of at least one high harmonic component of the modified reference signal (50), injected parasitically into a spectrum of electromagnetic signals, and present (42) in the filtered intermediate signals (40).
